(19) **Europäisches Patentamt**

**European Patent Office**

**Office européen des brevets**

(11) **EP 0 955 677 B1**

(12) **FASCICULE DE BREVET EUROPEEN**

(45) Date de publication et mention
de la délivrance du brevet:
**18.10.2006 Bulletin 2006/42**

(51) Int Cl.:
***H01L 23/525*** *(2006.01)*

(21) Numéro de dépôt: **99401105.4**

(22) Date de dépôt: **06.05.1999**

(54) **Fusible de circuit intégré, à focalisation de courant**

Sicherung mit Stromfokussierung für eine integrierte Schaltung

Fuse with focus current for integrated circuit

(84) Etats contractants désignés:
**DE FR GB IT**

(30) Priorité: **07.05.1998 FR 9805742**

(43) Date de publication de la demande:
**10.11.1999 Bulletin 1999/45**

(73) Titulaires:
• **STMicroelectronics S.A.**
**92120 Montrouge (FR)**
• **FRANCE TELECOM**
**75015 Paris (FR)**
Etats contractants désignés:
**FR**

(72) Inventeurs:
• **Delpech, Philippe**
**83000 Toulon (FR)**
• **Revil, Nathalie**
**83000 Toulon (FR)**

(74) Mandataire: **Bentz, Jean-Paul et al**
**Novagraaf Technologies**
**Cabinet Ballot**
**122, rue Edouard Vaillant**
**92593 Levallois Perret Cedex (FR)**

(56) Documents cités:
**US-A- 5 572 050        US-A- 5 659 182**
**US-A- 5 708 291**

**Description**

La présente invention concerne le domaine des circuits intégrés et plus particulièrement un fusible de circuit intégré.

La prévision de fusibles dans les circuits intégrés est une pratique courante pour l'homme de l'art, notamment dans le cadre de la fabrication des circuits MOS. Par exemple, il est classique de prévoir des fusibles pour protéger des grilles de transistors MOS contre l'accumulation de charges électrostatiques apparaissant pendant la fabrication des circuits intégrés. Ces fusibles sont ensuite claqués pour libérer les grilles des transistors. La prévision de lignes de mots ou de lignes de bits redondantes dans les mémoires à grande capacité repose également sur l'utilisation de fusibles, les lignes défectueuses ou inutilement redondantes étant ensuite isolées du reste de la mémoire par claquage des fusibles.

Ainsi, de façon générale, les fusibles présents dans les circuits intégrés sont destinés à être grillés par application d'une tension ou d'un courant de claquage, et permettent de modifier la configuration d'un circuit à un stade final de fabrication.

Le document US-A-5 708 291 décrit un fusible destiné à être disposé sur un substrat semi-conducteur. Ce fusible présente deux plages de contacts jointes par une liaison conductrice. La largeur de la liaison est très réduite par rapport à la largeur des plages. Cette liaison est destinée à fondre pour isoler les deux plages sous l'effet d'une tension prédéterminée appliquée entre les plages. Le fusible présente une zone de transition entre chaque plage et la liaison, présentant une section décroissant linéairement en formant un angle de 45° avec la liaison.

Le document US-A-5 321 322 décrit une architecture comprenant plusieurs types de fusibles interconnectés, de façon à supprimer sélectivement des connexions entre différents circuits. Les architectures décrites comprennent des fusibles à deux états et des fusibles à trois états. Des fusibles présentant des seuils de claquage différents sont utilisés. L'application sur plusieurs bornes de courants de claquage est modifiée en fonction du fusible dont le claquement est souhaité.

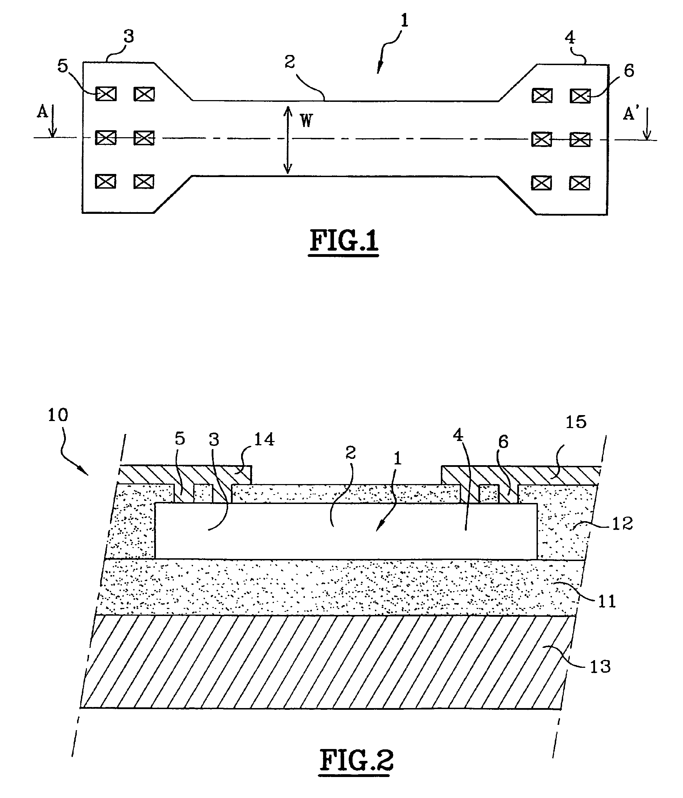

La présente invention concerne plus particulièrement un fusible 1 du type représenté sur la figure 1, comprenant une région centrale 2 en forme de barreau s'épanouissant à ses extrémités pour former deux plages 3, 4 recevant une pluralité de contacts électriques 5, 6. En général, comme représenté sur la figure 2 par une vue en coupe, le fusible 1 est enterré dans un circuit intégré 10 où il se trouve pris en sandwich entre une couche inférieure 11 et une couche supérieure 12 d'oxyde déposées sur un substrat de silicium 13. Les contacts 5,6 prennent la forme d'orifices métallisés traversant la couche d'oxyde 12 pour relier les plages 3, 4 à des conducteurs 14, 15. Classiquement, l'ensemble est réalisé par dépôt successif de diverses couches d'oxyde, de métal et/ou de polysilicium et gravure des couches par photolithographie.

Afin que la densité de courant dans le fusible 1 et l'efficacité du claquage soient maximales pour un courant de claquage donné, il est d'usage que la largeur W de la région centrale 2 du fusible soit choisie égale au minimum technologique offert par la technologie de fabrication du circuit intégré 10. A titre d'exemple, il est courant à l'heure actuelle que le minimum technologique en photolithographie soit de l'ordre de 0,25 micromètre en ce qui concerne la largeur minimale d'un conducteur.

Cette précaution ne représente toutefois qu'un avantage relatif étant donné que le minimum technologique détermine également la taille des autres composants présents dans le circuit intégré 10, notamment des transistors, et leur capacité à résister aux tensions ou aux courants élevés. Ainsi, ces dernières années, la diminution du minimum technologique grâce au perfectionnement des technologies est allée de pair avec une diminution des tensions et courants de claquage admissibles. A titre d'exemple, les tensions de claquage maximales autorisées dans les circuits à moyenne intégration de technologie ancienne sont de l'ordre de 5,5 à 6 Volt et ne sont plus que de 1,8 à 2 Volt avec les circuits à forte intégration de dernière génération.

Ainsi, malgré la prévision d'une largeur minimale, un fusible classique n'offre pas, statistiquement, un rendement de claquage égal à 100 % dans des conditions standard de claquage. En d'autres termes, lorsque l'on cherche à claquer simultanément un ensemble de fusibles présents dans un circuit intégré en appliquant une ou plusieurs impulsions de claquage, de courant ou de tension, il est fréquent qu'il subsiste des fusibles non claqués. Ces fusibles présentent une résistance électrique qui, bien que plus élevée que leur résistance électrique initiale, n'est pas assimilable à un circuit ouvert.

Il va de soi que cet inconvénient se répercute sur le rendement de fabrication des circuits intégrés et devient rédhibitoire lorsque l'on prévoit dans un même circuit intégré plusieurs dizaines voire plusieurs centaines de fusibles.

Un autre inconvénient des fusibles classiques est de n'être pas entièrement fiables, un certain pourcentage de fusibles claqués ayant tendance à se régénérer pour des raisons encore mal expliquées. En pratique, la régénération d'un fusible se traduit par le fait que ses propriétés d'isolement électrique se dégradent alors qu'elles étaient initialement satisfaisantes.

Enfin, le courant de claquage que l'on peut appliquer à un fusible sans dépasser une tension de claquage donnée est limité en pratique par la présence de résistances parasites formant, ensemble, une résistance d'accès au fusible. Il est connu que la résistance d'accès d'un fusible comprend la résistance des contacts électriques 5, 6, généralement de l'ordre de 5 Ω par contact, et la résistance des plages 3, 4 entre les contacts et la région centrale. La multiplication des contacts permet de diminuer la résistance d'accès mais le nombre de contacts pouvant être prévus demeure limité par la faible largeur de la région centrale 2 et la distribution des lignes de courant dans les plages 3,4. En d'autres termes, un élargissement des plages 3,4 pour ajouter encore d'autres contacts ne modifierait pratiquement pas la résistance d'accès.

Ainsi, un objectif général de la présente invention est de prévoir un fusible de circuit intégré qui claque plus facilement qu'un fusible classique, permettant notamment de réduire la tension de claquage appliquée aux bornes du fusible afin de répondre à la tendance de réduction des tensions d'alimentation.

Un autre objectif de la présente invention est de prévoir un fusible offrant un rendement de claquage supérieur aux fusibles classiques et une meilleure fiabilité.

Encore un objectif de la présente invention est de prévoir un fusible à faible résistance d'accès.

Ces objectifs sont atteints par la prévision d'un fusible de circuit intégré, formé par gravure d'une couche de polysilicium, de métal ou d'alliage, comprenant une région centrale à l'extrémité de laquelle se trouvent des plages pourvues de contacts électriques, dans lequel la région centrale présente au moins deux premiers bras électriquement en parallèle, et une zone de croisement des deux premiers bras formant un point de focalisation d'un courant de claquage facilitant le claquage du fusible par augmentation de la densité locale de courant.

Selon un mode de réalisation, la région centrale comprend au delà de la zone de croisement deux seconds bras agencés dans le prolongement des deux premiers bras.

Selon le mode de réalisation choisi, les bras peuvent être agencés à angle droit, et/ou être de même longueur, et/ou être de même largeur.

De préférence, les bras sont d'une largeur égale à un minimum technologique caractérisant la technologie de fabrication du fusible.

La présente invention concerne également un circuit intégré comprenant un fusible selon l'invention.

Ces objets, caractéristiques et avantages ainsi que d'autres de la présente invention seront exposés plus en détail dans la description suivante d'un exemple de réalisation d'un fusible selon l'invention, faite à titre non limitatif en relation avec les figures jointes parmi lesquelles :

- la figure 1 précédemment décrite est une vue de dessus d'un fusible classique,
- la figure 2 précédemment décrite est une vue en coupe selon un axe AA' représenté en figure 1 du fusible de la figure 1 agencé dans un circuit intégré,
- la figure 3 est une vue de dessus d'un fusible selon l'invention, et
- la figure 4 est le schéma électrique équivalent du fusible de la figure 3.

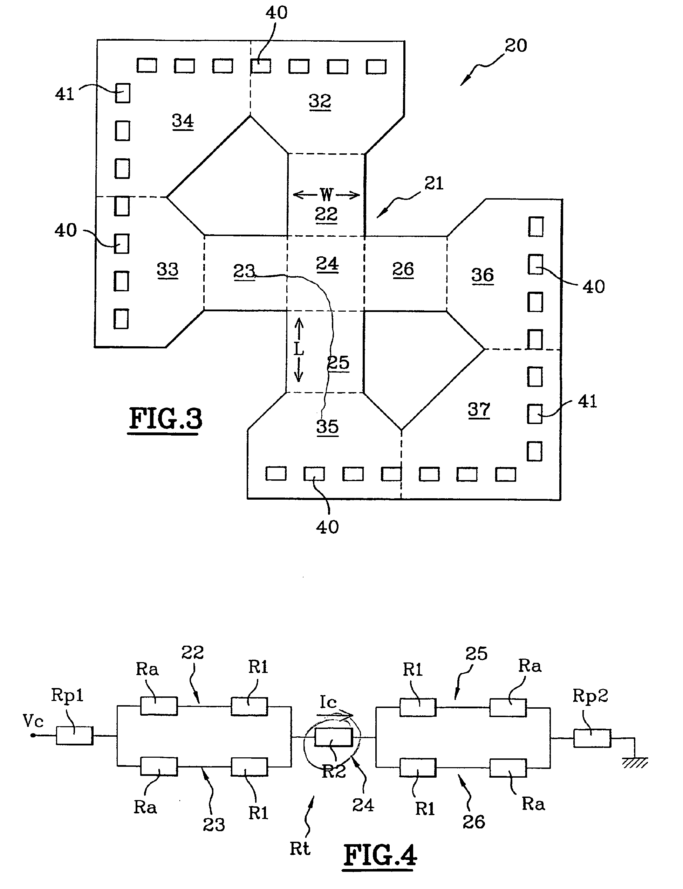

La figure 3 représente par une vue de dessus un fusible 20 de circuit intégré selon la présente invention. Essentiellement, le fusible 20 se distingue d'un fusible classique par le fait qu'il comprend une région centrale 21 en forme de croix correspondant à la superposition, avec un angle de 90°, de deux fusibles classiques en forme de barreaux.

Ainsi, le fusible 20 comprend, dans le sens de circulation d'un courant de claquage, deux premiers bras conducteurs 22, 23, une zone de croisement 24 où les deux bras 22, 23 ne forment plus qu'un seul élément conducteur, et deux seconds bras conducteurs 25, 26 agencés dans le prolongement des premiers bras 22, 23. De façon classique, les bras 22, 23, 25, 26 s'élargissent à leurs extrémités pour former des plages 32, 33, 35, 36 pourvues d'une pluralité de contacts électriques 40. De préférence, les plages de même potentiel électrique, respectivement 32, 33 et 35, 36, comportent une partie commune, respectivement 34, 37, également pourvue de contacts électriques 41.

Selon le mode de réalisation représenté sur la figure 3, les bras 22, 23, 25, 26 sont identiques et leur longueur L est égale à leur largeur W, la zone de croisement 24 ayant l'aspect d'un carré de largeur W. De préférence, la largeur W est égale au minimum technologique Wmin offert par la technologie de fabrication du fusible.

Le fusible 20 selon l'invention présente les avantages conjugués d'une faible résistance électrique et d'une forte concentration de courant dans la zone de croisement 24, ce qui lui confère un rendement de claquage élevé et une faible probabilité de régénération.

Pour fixer les idées sur ces avantages, la figure 4 représente le schéma électrique équivalent du fusible 20. Sur ce schéma, la résistance Rp1 représente la résistance d'un premier conducteur de circuit intégré amenant le courant de claquage au fusible. La résistance Rp2 représente la résistance d'un deuxième conducteur de circuit intégré conduisant à la masse. La résistance Ra représente la résistance d'accès à l'une des quatre extrémités de la région centrale du fusible, et comprend la résistance des contacts 40 présents sur une plage et la résistance de la plage elle-même (dans un souci de simplicité, on considère ici que la résistance d'accès Ra est identique pour chacune des plages). Enfin, la résistance R1 représente la résistance de chacun des bras du fusible et la résistance R2 représente la résistance de la zone de croisement 24.

A partir du schéma de la figure 4, on peut calculer que la résistance électrique totale Rt du fusible est sensi-

blement égale à :

$$(1) \qquad Rt = Rp1 + Rp2 + Ra + R1 + R2$$

Les bras 22, 23, 25, 26 et la zone de croisement 24 étant ici de même dimension, les résistances R1 et R2 sont identiques et égales à la résistance par unité de surface, ou résistance par carré $R_\square$, du matériau constituant le fusible 20. La relation (1) peut se simplifier et s'écrire :

$$(2) \qquad Rt = Rp1 + Rp2 + Ra + 2\ R_\square$$

En comparaison, la résistance totale Rt' d'un fusible classique en forme de barreau ayant une région centrale d'une longueur égale au triple de sa largeur, formée par un matériau de même conductivité, est égale à :

$$(3) \qquad Rt' = Rp1 + Rp2 + 2\ Ra + 3\ R_\square$$

Ainsi, vis-à-vis d'un fusible de l'art antérieur, le fusible 20 selon l'invention présente avantageusement une résistance d'accès Ra diminuée de moitié et une résistance de la région centrale 21 diminuée dans un rapport 2/3. Il est bien évident que ce rapport va en diminuant si l'on augmente, dans une variante de réalisation, la longueur des bras 22, 23, 25, 26.

En pratique, la résistance $R_\square$ d'un carré étant généralement faible devant la résistance totale Rt du fusible 20, le fusible selon l'invention peut donc être considéré comme l'équivalent de deux fusibles classiques en parallèle. Ainsi, pour une tension de claquage Vc donnée, on bénéficie d'un courant de claquage Ic plus important que dans l'art antérieur.

Ce courant de claquage Ic se répartit tout d'abord dans les deux bras 22, 23 puis se concentre dans la zone de croisement 24 où l'on observe une très forte densité de courant. La zone 24 forme ainsi un point faible facilitant le claquage du fusible. Plus particulièrement, la forte concentration de courant rend le claquage plus explosif et plus efficace, de sorte que le fusible selon l'invention offre un bon rendement de claquage et une fiabilité plus élevée que celle d'un fusible classique.

La zone de croisement 24 permet par ailleurs de localiser le point d'éclatement du fusible et d'éloigner ce point des plages 32 à 37 où se trouve une plus grande quantité de matière conductrice. Selon la demanderesse, et sous réserve d'études complémentaires devant être conduites sur les mécanismes de régénération des fusibles, cet aspect de l'invention est susceptible de contribuer à l'obtention d'une faible probabilité de régénération du fusible et par conséquent une meilleure fiabilité.

Toutefois, cette hypothèse ne sera pas considérée comme limitant la portée de l'invention et les divers modes de réalisation envisageables. Ainsi, par exemple, il est envisageable que les bras 25, 26 soient raccourcis, voire supprimés, de manière à diminuer l'encombrement du fusible. Dans ce cas, le point d'éclatement 24 du fusible se trouve à proximité des plages 35, 36, 37. Cette variante de réalisation, ainsi que d'autres, est susceptible d'études complémentaires à la portée de l'homme de l'art.

De façon générale, il est à la portée de l'homme de l'art de prévoir, tester et comparer diverses autres structures de fusibles selon l'invention, par exemple des structures en "Y", des structures à 5 bras, à 6 bras, etc., et d'étudier pour chaque structure la dimension optimale des bras, leur disposition, l'agencement et la forme du point de concentration du courant, permettant d'obtenir les meilleures performances.

En pratique, le fusible selon l'invention est destiné à être agencé dans un circuit intégré, par exemple entre deux couches d'oxyde, les contacts 40, 41 prenant alors la forme d'orifices métallisés débouchant sur des conducteurs. Outres les métaux et alliages classiquement utilisés en micro-électronique et se prêtant bien aux opérations de gravure par photolithographie, notamment Al, Ti, TiN, Ti/TiN, Cu, Al/Si, Al/Cu... le fusible peut également être réalisé par gravure d'une couche de polysilicium dopé, ayant subi de préférence un traitement de siliciuration, par exemple en présence de titane Ti, ou Co, W, Ta, permettant d'améliorer sa conductivité électrique.

Pour fixer les idées, en l'état actuel de la technologie, un fusible selon l'invention réalisé en polysilicium peut présenter une épaisseur de 0,2 micromètre pour une largeur W de chaque bras 22, 23, 25, 26 de l'ordre de 0,25 micromètre, et un fusible réalisé en métal peut présenter une épaisseur de 0,5 micromètre pour une largeur W de 0,4 micromètre.

**Revendications**

1. Fusible (20) de circuit intégré, formé par gravure d'une couche de polysilicium, de métal ou d'alliage, comprenant des pistes médianes (21) dont les extrémités comportent des plages (32, 33, 35, 36) pourvues de contacts électriques (40, 41) auxquels est appliqué une différence de potentiel pour claquer le fusible, **caractérisé en ce que** les pistes médianes (21) forment au moins deux premiers bras sécants (22,23), connectés en dérivation et se croisant en une zone d'intersection (24) formant un point de focalisation d'un courant de claquage (Ic) facilitant le claquage du fusible par augmentation de la densité locale de courant.

2. Fusible selon la revendication 1, dans lequel la région centrale (21) comprend au delà de la zone de croisement (24) deux seconds bras (25, 26) agencés dans le prolongement des deux premiers bras (22, 23).

3. Fusible selon l'une des revendications 1 et 2, comportant des bras (22, 23, 25, 26) agencés à angle droit.

4. Fusible selon l'une des revendications 1 à 3, comportant des bras (22, 23, 25, 26) de même longueur (L).

5. Fusible selon l'une des revendications 1 à 4, comportant des bras (22, 23, 25, 26) de même largeur (W).

6. Fusible selon la revendication 5, dans lequel les bras (22, 23, 25, 26) sont d'une largeur (W) égale à un minimum technologique (Wmin) caractérisant la technologie de fabrication du fusible.

7. Fusible selon l'une des revendications 1 à 6, réalisé en polysilicium siliciuré.

8. Fusible selon l'une des revendications 1 à 7, agencé entre deux couches d'oxyde.

9. Fusible selon l'une des revendications 1 à 8, dans lequel les contacts (40, 41) sont des orifices métallisés traversant une couche d'oxyde recouvrant le fusible pour atteindre des éléments conducteurs.

10. Circuit intégré, comprenant un fusible selon l'une des revendications précédentes.

**Claims**

1. Integrated-circuit fuse (20) formed by etching a polysilicon, metal or alloy layer, comprising central tracks (21), the ends of which have areas (32, 33, 35, 36) provided with electrical contacts (40, 41) to which a potential difference is applied in order to make the fuse blow, **characterized in that** the central tracks (21) form at least two first intersecting arms (22, 23) connected in parallel and crossing in an intersection region (24) forming a focal spot for a blowing current (Ic), making it easier for the fuse to blow by increasing the local current density.

2. Fuse according to Claim 1, in which the central region (21), comprises, beyond the cross-over zone (24), two second arms (25, 26) arranged in the extension of the two first arms (22, 23).

3. Fuse according to either of Claims 1 and 2, having arms (22, 23, 25, 26) arranged at right angles.

4. Fuse according to one of Claims 1 to 3, having arms (22, 23, 25, 26) of equal length (L).

5. Fuse according to one of Claims 1 to 4, having arms (22, 23, 25, 26) of equal width (W).

6. Fuse according to Claim 5, in which the arms (22, 23, 25, 26) have a width (W) equal to the technological minimum ($W_{min}$) that characterizes the technology for fabricating the fuse.

7. Fuse according to one of Claims 1 to 6, made of silicided polysilicon.

8. Fuse according to one of Claims 1 to 7, placed between two oxide layers.

9. Fuse according to one of Claims 1 to 8, in which the contacts (40, 41) are metallized orifices that pass through an oxide layer covering the fuse so as to reach conducting elements.

**10.** Integrated circuit, comprising a fuse according to one of the preceding claims.

**Patentansprüche**

**1.** Sicherung (20) eines integrierten Schaltkreises, gebildet durch Ätzen einer Polysiliconschicht, aus Metall oder aus einer Legierung, umfassend Mittelbahnen (21), von welchen die Enden Bereiche (32, 33, 35, 36) aufweisen, die mit elektrischen Kontakten (40, 41) versehen sind, an welche eine Potentialdifferenz angewandt wird, um die Sicherung zu schmelzen, **dadurch gekennzeichnet, dass** die Mittelbahnen (21) mindestens zwei erste sich schneidende Schenkel (22, 23) bilden, die an einer Abzweigung verbunden sind und sich in einer Schnittzone (24) schneiden, wobei sie einen Bündelungspunkt eines Schmelzstroms (Ic) bilden, der das Schmelzen der Sicherung durch Erhöhung der lokalen Stromdichte erleichtert.

**2.** Sicherung gemäß Anspruch 1, bei welcher der mittlere Bereich (21) jenseits der Kreuzungszone (24) zwei zweite Schenkel (25, 26) umfasst, die in der Verlängerung der zwei ersten Schenkel (22, 23) angeordnet sind.

**3.** Sicherung gemäß einem der Ansprüche 1 und 2, umfassend Schenkel (22, 23, 25, 26), die in einem rechten Winkel angeordnet sind.

**4.** Sicherung gemäß einem der Ansprüche 1 bis 3, umfassend Schenkel (22, 23, 25, 26) von gleicher Länge (L).

**5.** Sicherung gemäß einem der Ansprüche 1 bis 4, umfassend Schenkel (22, 23, 25, 26) von gleicher Breite (W).

**6.** Sicherung gemäß Anspruch 5, bei welcher die Schenkel (22, 23, 25, 26) von einer Breite (W) sind, die gleich einem technologischen Minimum (Wmin) ist, welches die Herstellungstechnologie der Sicherung kennzeichnet.

**7.** Sicherung gemäß einem der Ansprüche 1 bis 6, welche aus siliziertem Polysilizium hergestellt ist.

**8.** Sicherung gemäß einem der Ansprüche 1 bis 7, welche zwischen zwei Oxidschichten angeordnet ist.

**9.** Sicherung gemäß einem der Ansprüche 1 bis 8, in welcher die Kontakte (40, 41) metallisierte Öffnungen sind, die eine Oxidschicht durchdringen, die die Sicherung abdeckt, um leitfähige Elemente zu erreichen.

**10.** Integrierter Schaltkreis, umfassend eine Sicherung gemäß einem der vorhergehenden Ansprüche.

**FIG.1**

**FIG.2**

40

41

20

34
32

40

21
W
22

33

23  24  26  36

L
25

40

41

35  37

**FIG.3**

40

Rp1

Vc

22
Ra      R1

23
Ra      R1

Ic
R2

24

Rt

25
R1      Ra

26
R1      Ra

Rp2

**FIG.4**